# EUROPÄISCHE PATENTSCHRIFT

(11) **EP 0 890 987 B1**
(45) Veröffentlichungstag und Bekanntmachung des Hinweises auf die Patenterteilung: **05.03.2003**
(21) Anmeldenummer: 98111316.0
(22) Anmeldetag: 19.06.1998
(51) Int. Cl.: H01L 23/49

(54) **Feinstdraht aus einer Goldlegierung, Verfahren zu seiner Herstellung und seine Verwendung**
Fine wire of a gold alloy, method of making the same and its use
Fil fin d'un alliage d'or, procédé de sa fabrication et son utilisation

(30) Priorität: 07.07.1997 DE 19728871; 06.08.1997 DE 19733954
(43) Veröffentlichungstag der Anmeldung: 13.01.1999
(73) Patentinhaber: W.C. Heraeus GmbH & Co. KG, 63450 Hanau (DE)
(72) Erfinder: Herklotz, Günther, Dr., 63486 Bruchköbel (DE); Reuel, Jürgen, 63571 Gelnhausen (DE); Schräpler, Lutz, 63755 Alzenau (DE); Simons, Christoph, Dr., 63599 Biebergemünd (DE)
(74) Vertreter: Kühn, Hans-Christian

(56) Entgegenhaltungen:
- DE-B- 1 608 161
- PATENT ABSTRACTS OF JAPAN vol. 1997, no. 03, 31. März 1997 (1997-03-31) & JP 08 293516 A (NIPPON STEEL CORP), 5. November 1996 (1996-11-05)
- PATENT ABSTRACTS OF JAPAN vol. 1997, no. 03, 31. März 1997 (1997-03-31) & JP 08 291348 A (NIPPON STEEL CORP), 5. November 1996 (1996-11-05)
- PATENT ABSTRACTS OF JAPAN vol. 1997, no. 03, 31. März 1997 (1997-03-31) & JP 08 293514 A (NIPPON STEEL CORP), 5. November 1996 (1996-11-05)

## Beschreibung

Die Erfindung betrifft einen Feinstdraht aus einer Cer-Mischmetall enthaltenden Gold-Legierung zum Kontaktieren von Halbleiterbauelementen, ein Verfahren zu seiner Herstellung und seine Verwendung.

Zum Kontaktieren - Bonden - von Halbleiterbauelementen geeignete Drähte - auch als Bonddrähte bezeichnet - müssen gute elektrische Eigenschaften besitzen und gute mechanische Festigkeitswerte aufweisen. Der Durchmesser der Drähte kann etwa 10 - 200 Mikrometer betragen und liegt üblicherweise bei etwa 20 - 60 Mikrometer; er wird dem Anwendungszweck entsprechend gewählt.

Die Bonddrähte bestehen häufig aus Gold hoher Reinheit oder aus seltenerdmetallhaltigen Goldlegierungen.

So ist zum Beispiel aus DE 16 08 161 C die Verwendung einer Legierung aus Gold und 0,001 - 0,1 % eines oder mehrerer Seltenerdmetalle, besonders in Form von Cer-Mischmetall, oder Yttrium zur Herstellung von Zuführungsdrähten in integrierten Schaltungen bekannt. Diese Legierung des Goldes mit geringen Mengen an Seltenerdmetallen oder Yttrium besitzt bei Erwärmungstemperaturen bis zu 500 °C ein wesentlich verbessertes Festigkeits- und Dehnungsverhalten, ohne daß andere Eigenschaften des Goldes, wie Härte, chemische Beständigkeit oder elektrischer Widerstand, wesentlich beeinflußt werden.

Gold-Seltenerdmetall-Legierungen für Bonddrähte werden auch in DE 32 37 385 A (US 4 885 135), DE 39 36 281 A (US 4 938 923), JP 5-179375 A, JP 5-179376 A, JP 6-112258 A, EP 0 743 679 A und EP 0 761 831 A beschrieben.

DE 32 37 385 A betrifft einen Feingoldlegierungsdraht mit hoher Zugfestigkeit aus einer Goldlegierung mit 0,0003 - 0,01 Gewichts-% Seltenerdmetall, besonders Cer, und gegebenenfalls zusätzlich noch Germanium, Beryllium und/oder Calcium.

DE 39 36 281 A beschreibt einen Golddraht für das Verbinden einer Halbleitervorrichtung aus Gold hoher Reinheit, legiert mit geringen Mengen Lanthan, Beryllium, Calcium und Elementen der Platingruppe, besonders Platin und/oder Palladium.

JP 5-179375 A und JP 5-179376 A beziehen sich auf Feingoldlegierungsdrähte zum Bonden, die aus Gold hoher Reinheit und 0,0003 - 0,005 Gewichts-% Aluminium beziehungsweise Gallium, 0,0003 - 0,003 Gewichts-% Calcium und 0,0003 - 0,003 Gewichts-% Yttrium, Lanthan, Cer, Neodym, Dysprosium und/oder Beryllium bestehen.

Der aus JP 6-112258 A, referiert in Chemical Abstracts Vol.121, 89287m, bekannte Bonddraht besteht aus einer Gold-Legierung mit 1 - 30 % Platin und 0,0001 - 0,05 % Scandium, Yttrium und/oder Seltenerdmetall und gegebenenfalls 0,0001 - 0,05 % Beryllium, Calcium, Germanium, Nickel, Eisen, Kobalt und/oder Silber.

In EP 0 743 679 A wird ebenfalls ein Bonddraht aus einer platinhaltigen Gold-Seltenerdmetall-Legierung vorgeschlagen. Die Legierung besteht aus Gold und geringen Mengen Platin (0,0001 - 0,005 Gewichts-%), Silber, Magnesium und Europium und kann zum Beispiel noch Cer in einer Menge von 0,0001 - 0,02 Gewichts-% enthalten.

In EP 0761 831 A wird ein Feindraht aus einer Platin und/oder Palladium enthaltenden Gold-Seltenerdmetall-Legierung beschrieben. Die Legierung besteht aus 0,1 - 2,2 Gewichts-% Platin und/oder Palladium, 0,0001 - 0,005 Gewichts-% Beryllium, Germanium, Calcium, Lanthan, Yttrium und/oder Europium, Rest Gold. Der Draht wird durch Schmelzen der die Legierung bildenden Elemente in einem Tiegel, von unten nach oben fortschreitender Kühlung der in dem Tiegel befindlichen Legierungsschmelze zu einem Gußstück (ingot) und anschließendes Walzen, Ziehen und Glühen hergestellt. Er weist eine Dehnung von 3 - 8 % und einen Young-Modul von 6800 - 9000 kgf/mm² auf.

Aus JP 7-335685 A (Patent Abstracts of Japan) ist ein Bonddraht aus Gold, 0,1 - 0,8 Gewichts-% Platin und 0,0003 - 0,01 Gewichts-% Calcium, Beryllium, Germanium, Seltenerdmetall, Strontium, Barium, Indium, Zinn und/oder Titan bekannt.

JP 8-293515 A (Patent Abstracts of Japan) bezieht sich ebenfalls auf Bonddrähte aus Gold-Platin-Legierungen. Die Gold-Legierungen enthalten neben Gold 0,04 - 1,5 Gewichts-% Platin, 0,004 - 0,06 Gewichts-% Yttrium, Calcium, Lanthan und/oder Cer und gegebenenfalls zusätzlich noch 0,0005 - 0,05 Gewichts-% Aluminium und/oder Indium.

In JP 6-112254 A (Patents Abstract of Japan) wird die Herstellung eines Bonddrahtes aus einer Mischung aus Gold, 0,1 - 1 Gewichts-% Platin und 0,0001 - 0,005 Gewichts-% Eisen, Silicium, Beryllium, Calcium, Germanium, Yttrium, Scandium und/oder Seltenerdmetalle angegeben. Die Mischung wird geschmolzen und gegossen. Daran schließen sich Formwalzen, Glühen und Drahtziehen zur Bildung eines Drahtes mit einem Durchmesser von 25 Mikrometer an. Durch den Zusatz von Platin erhöht sich die Festigkeit des Bonddrahtes, wodurch Ausfälle bei einem Hochtemperatur-Test geringer werden.

In JP 6-112256 A (Patents Abstracts of Japan) wird die Herstellung eines Bonddrahtes aus einer Mischung aus Gold, 0,003 - 0,1 Gewichts-% Palladium, Platin, Rhodium, Iridium, Osmium und/oder Ruthenium und 0,0001 - 0,05 Gewichts-% Scandium, Yttrium und/oder Seltenerdmetalle angegeben. Die Mischung wird geschmolzen und gegossen. Daran schließen sich Formwalzen, Glühen und Drahtziehen zur Bildung eines Drahtes mit einem Durchmesser von 25 Mikrometer an. Durch den Zusatz der Platingruppenmetalle erhöht sich die Festigkeit des Bonddrahtes, wodurch Ausfälle bei einem Hochtemperatur-Test geringer werden.

JP 2-91944 A (Patents Abstracts of Japan) betrifft einen für Gold-Bumps geeigneten Gold-Feindraht aus einer Gold-Legierung, die neben Gold 0,5 - 10 Gewichts-% Palladium und 0,0001 bis 0,02 Gewichts-% Lanthan, Cer und/oder Calcium enthält.

DE 44 42 960 C, betrifft Lothöcker (Bumps) für die Flip-Chip-Montage und Verfahren zu deren Herstellung. Die Lothöcker-Kerne können als Ball-Bumps mechanisch unter Verwendung eines Drahtmaterials aus 98 % Gold und 2 % Palladium hergestellt werden.

Bei der Auswahl von Bonddrähten wird neben speziellen chemischen und physikalischen Eigenschaften insbesondere auch eine möglichst hohe Festigkeit bei gegebener Dehnung gefordert.

Ausgehend von DE 16 08 161 C, liegt der Erfindung daher die Aufgabe zugrunde, einen Feinstdraht der eingangs charakterisierten Art aus einer Cer-Mischmetall enthaltenden Gold-Legierung zu finden, der ein möglichst gutes Festigkeits/Dehnungs-Verhältnis besitzt. Außerdem soll ein Verfahren angegeben werden, das eine kontinuierliche Herstellung des Feinstdrahtes in wirtschaftlich vorteilhafter Weise ermöglicht. Der Feinstdraht soll sowohl zum Drahtbonden als auch zur Herstellung von sogenannten Ball-Bumps für die Flip-Chip-Technik, wie sie zum Beispiel in DE 44 42 960 C beschrieben wird, geeignet sein.

Cer-Mischmetall ist nach Römpp Chemie Lexikon, Georg Thieme Verlag Stuttgart - New York, 9. Auflage, 1989, 625, eine Mischung-aus 45 - 60 % Cer, 15 - 30 % Lanthan, 10 - 20 % Neodym, 4 - 6 % Praseodym und 1 - 2 % Samarium, ferner 0,5 - 1 % Yttrium und häufig noch 0,5 - 1 % Eisen und Silicium, Kohlenstoff, Phosphor, Mangan, Magnesium und Calcium, nach Römpp Chemie Lexikon, 10. Auflage, 1996, 647, eine Mischung mit 50 - 60 % Cer, 25 - 30 % Lanthan, 10 - 15 % Neodym, 4 - 6 % Praseodym und 1 % Eisen sowie geringen Anteilen weiterer Seltenerdmetalle.

Der die Lösung der Aufgabe darstellende Feinstdraht ist erfindungsgemäß dadurch gekennzeichnet, daß die Gold-Legierung aus 0,05 - 0,95 Gewichts-% Platin, 0,001 - 0,1 Gewichts-% Cer-Mischmetall, 0 - 0,1 Gewichts-% Erdalkalimetall, Rest Gold und das Cer-Mischmetall zu mindestens 50 Gewichts-% aus Cer besteht.

Besonders bewährt hat sich der Feinstdraht, wenn der Platin-Gehalt der Gold-Legierung 0,25 bis 0,9 Gewichts-% beträgt. Günstigerweise liegt der Cer-Mischmetall-Gehalt bei 0,001 - 0,01 Gewichts-% und der Erdalkalimetall-Gehalt bei 0,0001 - 0,01 Gewichts-%.

Der erfindungsgemäße Feinstdraht mit für Bonddrähte üblichem Durchmesser besitzt alle für den Einsatz zum Bonden erforderlichen Eigenschaften. Er zeichnet sich besonders durch seine - bezogen auf die Dehnung - sehr gute Festigkeit aus. Überraschenderweise führt die erfindungsgemäße Auswahl von Art und Menge der Legierungsbildner - Cer-Mischmetall, Platin und gegebenenfalls Erdalkalimetall - zu dem sehr günstigen Festigkeits/Dehnungs-Verhältnis des Feinstdrahtes, das wesentlich zu der sehr guten Qualität der Bondverbindungen beiträgt.

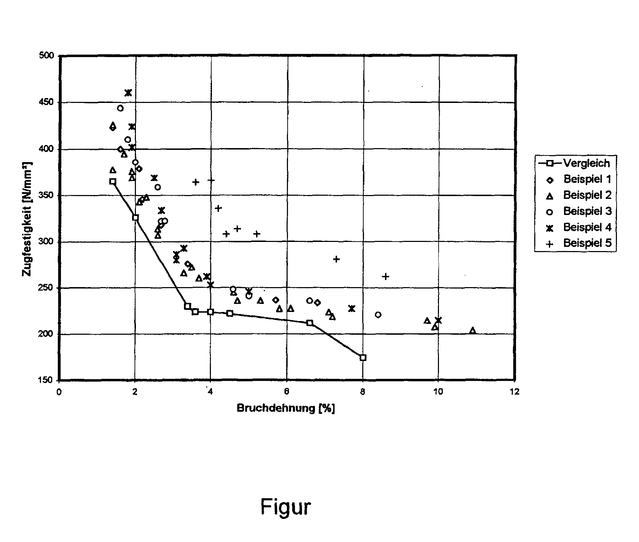

In der Figur wird die Festigkeit (Zugfestigkeit) [MPa] einiger Feinstdrähte gemäß der Erfindung (Beispiele 1 - 5) und - zum Vergleich - eines Feinstdrahtes gemäß dem aus DE 16 08 161 C bekannten Stand der Technik (Beispiel 6) in Abhängigkeit von der Dehnung (Bruchdehnung) [%] dargestellt. Die Feinstdrähte gemäß der Erfindung besitzen bei gegebener Dehnung eine höhere Festigkeit.

Der erfindungsgemäße Feinstdraht kann aufgrund seiner günstigen Eigenschaften mit besonderem Vorteil zum Drahtbonden, auch für das sich in Entwicklung befindende Hochfrequenz-Bonden, und zur Herstellung der Kontakthügel von Flip-Chips eingesetzt werden.

Die Lösung der Aufgabe besteht weiterhin in einem Verfahren zur Herstellung eines Feinstdrahtes zum Kontaktieren von Halbleiterbauelementen aus einer Cer-Mischmetall enthaltenden Gold-Legierung, das erfindungsgemäß dadurch gekennzeichnet ist, daß eine Gold-Legierung aus 0,05 - 0,95 Gewichts-% Platin, 0,001 - 0,1 Gewichts-% Cer-Mischmetall, 0 - 0,1 Gewichts-% Erdalkalimetall, Rest Gold, wobei das Cer-Mischmetall zu mindestens 50 Gewichts-% aus Cer besteht, erschmolzen, die geschmolzene Legierung strangvergossen, der Strang zu einem Draht mit für Bondzwecke üblichem Durchmesser gezogen und der Draht geglüht wird.

Das erfindungsgemäße Verfahren hat sich besonders bewährt, wenn die geschmolzene Legierung zu einem Strang mit kreisförmigem Querschnitt vergossen und der Draht bei etwa 300 - 700 °C geglüht wird. Durch das Glühen erhält der zunächst ziehharte Draht die erforderliche Dehnung. Das Erschmelzen und Vergießen der Legierung kann an Luft, unter Schutzgas, zum Beispiel Argon, oder im Vakuum erfolgen.

Bevorzugt wird bei dem erfindungsgemäßen Verfahren das Erschmelzen einer Gold-Legierung mit einem Platin-Gehalt von 0,25 - 0,9 Gewichts-%; ein Cer-Mischmetall-Gehalt von 0,001 bis 0,01 Gewichts-% und ein Erdalkalimetall-Gehalt von 0,0001 - 0,01 Gewichts-% haben sich als sehr günstig erwiesen.

Als Erdalkalimetall kann Beryllium, Magnesium, Calcium, Strontium, Barium oder ein Gemisch aus mindestens zwei dieser Elemente eingesetzt werden. Besonders bewährt hat sich eine Mischung aus Beryllium und Calcium, wobei eine aus etwa 50 Gewichts-% Beryllium und etwa 50 Gewichts-% Calcium bestehende Mischung bevorzugt wird.

Es kann von Vorteil sein, eine Legierung zu erschmelzen, in der das Platin teilweise oder vollständig durch Palladium ersetzt ist.

Das erfindungsgemäße Verfahren zeichnet sich besonders dadurch aus, daß es kontinuierlich zu führen ist und Verfahrensprodukte - gegossener Strang und gezogener Draht - mit sehr gleichmäßiger und gleichbleibender Qualität liefert.

Zur näheren Erläuterung werden in den folgenden Beispielen Feinstdrähte und ihre Herstellung gemäß der Erfindung (Beispiele 1 - 5) und - zum Vergleich - ein Feinstdraht gemäß dem aus DE 16 08 161 C bekannten Stand der Technik (Beispiel 6) beschrieben. Die Feinstdrähte werden durch ihre Dehnung (Bruchdehnung) [%] und Festigkeit (Zugfestigkeit) [MPa] charakterisiert. Das in den Beispielen eingesetzte Cer-Mischmetall ist ein Handelsprodukt mit einem Cer-Gehalt von über 50 Gewichts-%.

### Beispiel 1

### Feinstdraht aus einer Gold-Legierung mit 0,25 Gewichts-% Platin und 0,003 Gewichts-% Cer-Mischmetall

Die Schmelze einer Legierung aus 0,25 Gewichts-% Platin, 0,003 Gewichts-% Cer-Mischmetall und Gold als Rest wird in einer Stranggußanlage zu einem Strang mit kreisförmigem Querschnitt vergossen. Anschließend wird aus dem Strang ein Draht mit einem Durchmesser von 30 Mikrometer gezogen und der Draht je nach zu erzielender Dehnung bei etwa 300 - 600 °C an Luft geglüht. Die in Abhängigkeit von der Dehnung [%] gemessenen Festigkeitswerte [MPa] werden in der Tabelle I angegeben.

Der spezifische elektrische Widerstand bei Raumtemperatur, gemessen an einem Draht mit einem Durchmesser von 275 Mikrometer, beträgt 0,026 Ohm mm²/m.

**Tabelle I**

| Dehnung [%] | Festigkeit [MPa] |
|---|---|
| 1,4* | 423* |
| 1,6 | 400 |
| 2,1 | 379 |
| 2,2 | 346 |
| 2,7 | 318 |
| 3,4 | 276 |
| 5,7 | 237 |
| 6,8 | 234 |
| 8,4 | 221 |

### Beispiel 2

### Feinstdraht aus einer Gold-Legierung mit 0,5 Gewichts-% Platin und 0,003 Gewichts-% Cer-Mischmetall

Die Schmelze einer Legierung aus 0,5 Gewichts-% Platin, 0,003 Gewichts-% Cer-Mischmetall und Gold als Rest wird in einer Stranggußanlage zu einem Strang mit kreisförmigem Querschnitt vergossen. Anschließend wird aus dem Strang ein Draht mit einem Durchmesser von 30 Mikrometer gezogen und der Draht je nach zu erzielender Dehnung bei etwa 300 - 600 °C an Luft geglüht. Die in Abhängigkeit von der Dehnung [%] gemessenen Festigkeitswerte [MPa] werden in der Tabelle II angegeben.

Der spezifische elektrische Widerstand bei Raumtemperatur, gemessen an einem Draht mit einem Durchmesser von 275 Mikrometer, beträgt 0,028 Ohm mm²/m.

**Tabelle II**

| Dehnung [%] | Festigkeit [MPa] |
|---|---|
| 1,4* | 426* |
| 1,4 | 378 |
| 1,7 | 395 |
| 1,9 | 369 |
| 1,9 | 376 |
| 2,1 | 343 |
| 2,3 | 348 |
| 2,6 | 307 |
| 2,6 | 314 |
| 3,3 | 266 |
| 3,5 | 272 |
| 3,7 | 260 |
| 4,6 | 245 |
| 4,7 | 236 |
| 5,3 | 236 |
| 5,8 | 228 |
| 6,1 | 228 |
| 7,1 | 224 |
| 7,2 | 219 |
| 9,7 | 215 |
| 9,9 | 208 |
| 10,9 | 204 |

### Beispiel 3

### Feinstdraht aus einer Gold-Legierung mit 0,75 Gewichts-% Platin und 0,003 Gewichts-% Cer-Mischmetall

Die Schmelze einer Legierung aus 0,75 Gewichts-% Platin, 0,003 Gewichts-% Cer-Mischmetall und Gold als Rest wird in einer Stranggußanlage zu einem Strang mit kreisförmigem Querschnitt vergossen. Anschließend wird aus dem Strang ein Draht mit einem Durchmesser von 30 Mikrometer gezogen und der Draht je nach zu erzielender Dehnung bei etwa 300 - 600 °C an Luft geglüht. Die in Abhängigkeit von der Dehnung [%] gemessenen Festigkeitswerte [MPa] werden in der Tabelle III angegeben.

Der spezifische elektrische Widerstand bei Raumtemperatur, gemessen an einem Draht mit einem Durchmesser von 275 Mikrometer, beträgt 0,031 Ohm mm²/m.

**Tabelle III**

| Dehnung [%] | Festigkeit [MPa] |
|---|---|
| 1,6* | 444* |
| 1,8 | 410 |
| 2,0 | 386 |
| 2,6 | 359 |
| 2,7 | 322 |
| 2,8 | 322 |
| 4,0 | 252 |
| 4,6 | 248 |
| 5,0 | 241 |
| 6,6 | 236 |
| 8,4 | 221 |

### Beispiel 4

### Feinstdraht aus einer Gold-Legierung mit 0,9 Gewichts-% Platin und 0,003 Gewichts-% Cer-Mischmetall

Die Schmelze einer Legierung aus 0,9 Gewichts-% Platin, 0,003 Gewichts-% Cer-Mischmetall und Gold als Rest wird in einer Stranggußanlage zu einem Strang mit kreisförmigem Querschnitt vergossen. Anschließend wird aus dem Strang ein Draht mit einem Durchmesser von 25 Mikrometer und ein Draht mit einem Durchmesser von 30 Mikrometer gezogen und jeder Draht je nach zu erzielender Dehnung bei etwa 300 - 600 °C an Luft geglüht. Die in Abhängigkeit von der Dehnung [%] gemessenen Festigkeitswerte [MPa] werden in der TabelleIV angegeben.

Der spezifische elektrische Widerstand bei Raumtemperatur, gemessen an einem D raht mit einem Durchmesser von 275 Mikrometer, beträgt 0,032 Ohm mm ?m.

**Tabelle IV**

| Dehnung [%] | Festigkeit [MPa] |
|---|---|
| 1,8* | 460* |
| 1,9 | 424 |
| 1,9 | 402 |
| 2,5 | 369 |
| 2,7 | 334 |
| 3,1 | 280 |
| 3,1 | 286 |
| 3,3 | 293 |
| 3,9 | 262 |
| 4,0 | 253 |
| 5,0 | 246 |
| 7,7 | 228 |
| 10,0 | 215 |

### Beispiel 5

### Feinstdraht aus einer Gold-Legierung mit 0,9 Gewichts-% Platin, 0,003 Gewichts-% Cer-Mischmetall, 0,001 Gewichts-% Beryllium und 0,001 Gewichts-% Calcium

Die Schmelze einer Legierung aus 0,9 Gewichts-% Platin, 0,003 Gewichts-% Cer-Mischmetall, 0,001 Gewichts-% Beryllium, 0,001 Gewichts-% Calcium und Gold als Rest wird in einer Stranggußanlage zu einem Strang mit kreisförmigem Querschnitt vergossen. Anschließend wird aus dem Strang ein Draht mit einem Durchmesser von 30 Mikrometer gezogen und je nach zu erzielender Dehnung bei etwa 300 - 600 °C an Luft geglüht. Die in Abhängigkeit von der Dehnung [%] gemessenen Festigkeitswerte [MPa] werden in der Tabelle V angegeben.

**Tabelle V**

| Dehnung [%] | Festigkeit [MPa] |
|---|---|
| 3,6 | 364 |
| 4,0 | 366 |
| 4,2 | 336 |
| 4,4 | 308 |
| 4,7 | 314 |
| 5,2 | 308 |
| 7,3 | 281 |
| 8,6 | 262 |

### Beispiel 6 (Vergleich)

### Feinstdraht aus einer Gold-Legierung mit Cer-Mischmetall gemäß DE 16 08 161 C

Die Schmelze einer Legierung aus Gold und Cer-Mischmetall wird in einer Stranggußanlage zu einem Strang mit kreisförmigem Querschnitt vergossen. Anschließend wird aus dem Strang ein Draht mit einem Durchmesser von 25 Mikrometer und ein Draht mit einem Durchmesser von 30 Mikrometer gezogen und jeder Draht je nach zu erzielender Dehnung bei etwa 300 - 600 °C an Luft geglüht. Die in Abhängigkeit von der Dehnung [%] gemessenen Festigkeitswerte [MPa] werden in der Tabelle V angegeben.

Der spezifische elektrische Widerstand bei Raumtemperatur, gemessen an einem Draht mit einem Durchmesser von 275 Mikrometer, beträgt 0,024 Ohm mm²/m.

**Tabelle VI**

| Dehnung [%] | Festigkeit [MPa] |
|---|---|
| 1,4* | 365* |
| 2,0 | 326 |
| 3,4 | 230 |
| 3,6 | 224 |
| 4,0 | 224 |
| 4,5 | 222 |
| 6,6 | 212 |
| 8,0 | 175 |

| | |
|---|---|
| * ziehhart | |

## Patentansprüche

1. Feinstdraht aus einer Cer-Mischmetall enthaltenden Gold-Legierung zum Kontaktieren von Halbleiterbauelementen, **dadurch gekennzeichnet, daß** die Gold-Legierung aus 0,05 - 0,95 Gewichts-% Platin, 0,001 - 0,1 Gewichts-% Cer-Mischmetall, 0 - 0,1 Gewichts-% Erdalkalimetall, Rest Gold und das Cer-Mischmetall zu mindestens 50 Gewichts-% aus Cer besteht

2. Feinstdraht nach Anspruch 1, **dadurch gekennzeichnet, daß** der Platin-Gehalt der Gold-Legierung 0,25 - 0,9 Gewichts-% beträgt.

3. Feinstdraht nach Anspruch 1 oder 2, **dadurch gekennzeichnet, daß** der Cer-Mischmetall-Gehalt der Gold-Legierung 0,001 - 0,01 Gewichts-% beträgt.

4. Feinstdraht nach einem der Ansprüche 1 bis 3, **dadurch gekennzeichnet, daß** der Erdalkalimetall-Gehalt der Gold-Legierung 0,0001 - 0,01 Gewichts-% beträgt.

5. Feinstdraht nach einem der Ansprüche 1 bis 4, **dadurch gekennzeichnet, daß** das Erdalkalimetall eine Mischung aus Beryllium und Calcium ist.

6. Feinstdraht nach einem der Ansprüche 1 bis 5, **dadurch gekennzeichnet, daß** das Platin teilweise oder vollständig durch Palladium ersetzt ist.

7. Verfahren zur Herstellung eines Feinstdrahtes aus einer Cer-Mischmetall enthaltenden Gold-Legierung zum Kontaktieren von Halbleiterbauelementen nach einem der Ansprüche 1 - 6, **dadurch gekennzeichnet, daß** eine Gold-Legierung aus 0,05 - 0,95 Gewichts-% Platin, 0,001 - 0,1 Gewichts-% Cer-Mischmetall, 0 - 0,1 Gewichts-% Erdalkalimetall, Rest Gold, wobei das Cer-Mischmetall zu mindestens 50 Gewichts-% aus Cer besteht, erschmolzen, die geschmolzene Legierung strangvergossen, der Strang zu einem Draht mit für Bondzwecke üblichem Durchmesser gezogen und der Draht geglüht wird.

8. Verfahren nach Anspruch 7, **dadurch gekennzeichnet, daß** die geschmolzene Legierung zu einem Strang mit kreisförmigem Querschnitt vergossen wird.

9. Verfahren nach Anspruch 7 oder 8, **dadurch gekennzeichnet, daß** eine Gold-Platin-Seltenerdmetall-Legierung mit einem Platin-Gehalt von 0,25 - 0,9 Gewichts-% erschmolzen wird.

10. Verfahren nach einem der Ansprüche 7 bis 9, **dadurch gekennzeichnet, daß** eine Gold-Legierung mit einem Cer-Mischmetall-Gehalt von 0,001 - 0,01 Gewichts-% erschmolzen wird.

11. Verfahren nach einem der Ansprüche 7 bis 10, **dadurch gekennzeichnet, daß** eine Gold-Legierung mit einem Erdalkalimetall-Gehalt von 0,0001 - 0,01 Gewichts-% erschmolzen wird.

12. Verfahren nach einem der Ansprüche 7 bis 11, **dadurch gekennzeichnet, daß** eine Gold-Legierung, die als Erdalkalimetall eine Mischung aus Beryllium und Calcium enthält, erschmolzen wird.

13. Verfahren nach einem der Ansprüche 7 bis 12, dadurch gekennzeichet, daß eine Gold-Legierung erschmolzen wird, in der das Platin teilweise oder vollständig durch Palladium ersetzt ist.

14. Verfahren nach einem der Ansprüche 7 bis 13, **dadurch gekennzeichnet, daß** der Draht bei 300 - 700 °C geglüht wird.

15. Verwendung des Feinstdrahtes nach einem der Ansprüche 1 bis 6 zum Drahtbonden.

16. Verwendung nach Anspruch 15 zum Drahtbonden unter Hochfrequenz-Anwendung.

17. Verwendung des Feinstdrahtes nach einem der Ansprüche 1 bis 6 zum Verbinden von Halbleiterbauelementen in Flip-Chip-Technik.

## Claims

1. Very fine wire comprising a gold alloy containing cerium mixed metal, for bonding semiconductor components, **characterized in that** the gold alloy consists of 0.05 - 0.95% by weight of platinum, 0.001 - 0.1% by weight of cerium mixed metal and 0 - 0.1% by weight of alkaline earth metal, the remainder being gold, and the cerium mixed metal comprises at least 50% by weight of cerium.

2. Very fine wire according to Claim 1, **characterized in that** the platinum content of the gold alloy is 0.25 - 0.9% by weight.

3. Very fine wire according to Claim 1 or 2, **characterized in that** the cerium mixed metal content of the gold alloy is 0.001 - 0.01% by weight.

4. Very fine wire according to any of Claims 1 to 3, **characterized in that** the alkaline earth metal content of the gold alloy is 0.0001 - 0.01% by weight.

5. Very fine wire according to any of Claims 1 to 4, **characterized in that** the alkaline earth metal is a mixture of beryllium and calcium.

6. Very fine wire according to any of Claims 1 to 5, **characterized in that** the platinum is partly or completely replaced by palladium.

7. Process for the production of a very fine wire comprising a gold alloy containing cerium mixed metal, for bonding semiconductor components, as claimed in any of Claims 1-6, **characterized in that** a gold alloy comprising 0.05 - 0.95% by weight of platinum, 0.001 - 0.1% by weight of cerium mixed metal and 0 - 0.1% by weight of alkaline earth metal, the remainder being gold, and the cerium mixed metal comprising at least 50% by weight of cerium, is melted, the molten alloy is continuously cast, the strand is drawn to give a wire having a diameter customary for bonding purposes and the wire is annealed.

8. Process according to Claim 7, **characterized in that** the molten alloy is cast to give a strand having a circular cross-section.

9. Process according to Claim 7 or 8, **characterized in that** a gold-platinum-rare earth metal alloy having a platinum content of 0.25 - 0.9% by weight is melted.

10. Process according to any of Claims 7 to 9, **characterized in that** a gold alloy having a cerium mixed metal content of 0.001 - 0.01% by weight is melted.

11. Process according to any of Claims 7 to 10, **characterized in that** a gold alloy having an alkaline earth metal content of 0.0001 - 0.01% by weight is melted.

12. Process according to any of Claims 7 to 11, **characterized in that** a gold alloy which contains a mixture of beryllium and calcium as alkaline earth metal is melted.

13. Process according to any of Claims 7 to 12, **characterized in that** a gold alloy in which the platinum has been partly or completely replaced by palladium is melted.

14. Process according to any of Claims 7 to 13, **characterized in that** the wire is annealed at 300 - 700°C.

15. Use of the very fine wire according to any of Claims 1 to 6 for wire bonding.

16. Use according to Claim 15 for wire bonding with the use of high frequency.

17. Use of the very fine wire according to any of Claims 1 to 6 for connecting semiconductor components in the flip-chip technique.

## Revendications

1. Fil superfin en alliage d'or contenant un mischmétal de Cer pour le contact d'éléments constitutifs semi-conducteurs, **caractérisé en ce que** l'alliage d'or est constitué de 0,05 - 0,95% en poids de platine, 0,001 - 0,1% en poids de mischmétal de Cer, 0 - 0,1% en poids de métal alcalino-terreux, le reste étant de l'or et **en ce que** le mischmétal de Cer est constitué d'au moins 50% en poids de Cer.

2. Fil super fin selon la revendication 1, **caractérisé en ce que** la quantité de platine de l'alliage d'or est 0,25 - 0,9% en poids.

3. Fil superfin selon la revendication 1 ou 2, **caractérisé en ce que** la quantité de mischmétal de Cer de l'alliage d'or est 0,001 - 0,01% en poids.

4. Fil superfin selon l'une des revendications 1 à 3, **caractérisé en ce que** la quantité de métal alcalino-terreux de l'alliage d'or est 0,0001 - 0,01% en poids.

5. Fil superfin selon l'une des revendications 1 à 4, **caractérisé en ce que** le métal alcalino-terreux est un mélange de béryllium et de calcium.

6. Fil superfin selon l'une des revendications 1 à 5, **caractérisé en ce que** le platine est remplacé en partie ou totalement par du palladium.

7. Procédé de préparation d'un fil superfin en alliage d'or contenant un mischmétal de Cer pour le contact d'éléments constitutifs semi-conducteurs selon l'une des revendications 1 - 6, **caractérisé en ce qu'**on fond un alliage d'or contenant 0,05 - 0,95% en poids de platine, 0,001 - 0,1% en poids d'un mischmétal de Cer, 0 - 0,1% en poids d'un métal alcalino-terreux, le reste étant de l'or, dans lequel le mischmétal de Cer comprend au moins 50% en poids de Cer, on coule en brin l'alliage fondu, on étire le brin en un fil avec un diamètre habituel pour la liaison et on recuit le fil.

8. Procédé selon la revendication 7, **caractérisé en ce qu'**on coule l'alliage fondu en un brin, avec une coupe transversale en forme de cercle.

9. Procédé selon la revendication 7 ou 8, **caractérisé en ce qu'**on fond un alliage or-platine-métal alcalino-terreux avec une quantité de platine de 0,25 - 0,9% en poids.

10. Procédé selon l'une des revendications 7 à 9, **caractérisé en ce qu'**on fond un alliage d'or avec une quantité de mischmétal de Cer de 0,001 - 0,01% en poids.

11. Procédé selon l'une des revendications 7 à 10, **caractérisé en ce qu'**on fond un alliage d'or avec une quantité de métal alcalino-terreux de 0,0001 - 0,01% en poids.

12. Procédé selon l'une des revendications 7 à 11, **caractérisé en ce qu'**on fond un alliage d'or qui contient comme métal alcalino-terreux un mélange de béryllium et de calcium.

13. Procédé selon l'une des revendications 7 à 12, **caractérisé en ce qu'**on fond un alliage d'or, dans lequel le platine est remplacé en partie ou complètement par le palladium.

14. Procédé selon l'une des revendications 7 à 13, **caractérisé en ce qu'**on recuit le fil à 300 - 700°C.

15. Utilisation d'un fil superfin selon l'une des revendications 1 à 6, pour des liaisons de fils.

16. Utilisation selon la revendication 15, pour les liaisons de fils sous application sous haute fréquence.

17. Utilisation d'un fil superfin selon l'une des revendications 1 à 6, pour la liaison d'éléments constitutifs semi-conducteurs, dans la technique de flip-chip.
